# EUROPEAN PATENT APPLICATION

(11) **EP 1 460 688 A2**
(43) Date of publication of application: **22.09.2004**
(21) Application number: 04006380.2
(22) Date of filing: 17.03.2004
(51) Int. Cl.: H01L 23/31, H01L 23/495

(54) **Resin sealed electronic assembly and method of manufacturing the same**

(30) Priority: 17.03.2003 JP 2003071201
(71) Applicant: Hitachi, Ltd., Chiyoda-ku, Tokyo 101-8010 (JP)
(72) Inventor: Ishi, Toshiaki, c/o Hitachi, Ltd., Int. Prop. Gr., Tokyo 100-8220 (JP); Tsuyuno, Nobutake, c/o Hitachi, Ltd., Int. Prop. G, Tokyo 100-8220 (JP); Masuda, Mitsuhiro, c/o Hitachi, Ltd., Int. Prop. G, Tokyo 100-8220 (JP); Urushiwara, Noriyoshi, c/o Hitachi, Ltd., Int. Pr., Tokyo 100-8220 (JP); Matsushita, Akira, c/o Hitachi, Ltd., Int. Prop., Tokyo 100-8220 (JP)
(74) Representative: Beetz & Partner Patentanwälte

(57) **Abstract**

A resin-sealed electronic circuit apparatus capable of maintaining a high heat-dissipating property and packaging density in applications where high hermetic-sealing property and durability are required. The electronic circuit apparatus comprises at least two wiring circuit boards (12, 13) on which electronic components are mounted. The wiring circuit boards (12, 13) are fixed to a heat sink (14) having a high heat conductivity via an adhesive (9, 10). The entirety of the wiring circuit boards (12, 13) and heat sink (14), as well as a part of an external connection terminal (8) are hermetically sealed and integrally molded by a thermosetting resin composition (7). The electronic circuit apparatus is small and highly reliable and can be provided at low cost.

## Description

### BACKGROUND OF THE INVENTION

### 1. Technical Field

The present invention relates to an electronic circuit apparatus and a method of manufacturing the same. Particularly, the invention relates to a vehicle-mounted, resin-sealed type electronic circuit apparatus that has a relatively large exterior, generates a large amount of heat and is used under severe conditions including high temperatures. The invention also relates to a method of manufacturing the apparatus and a mounting structure for the apparatus.

### 2. Background Art

Electronic circuit apparatuses for automobiles, such as an engine control unit, are conventionally mounted inside the vehicle passenger compartment. With the increase in the number of such electronic circuit apparatuses and their harnessing parts, there is a growing need for mounting the electronic circuit apparatuses outside the passenger compartment in modular structures. Modular structures make it possible to reduce assembly costs.

With the adoption of the concept of modular structures, the engine control unit is mounted near the engine, and the transmission control unit is mounted on the exterior or interior of the transmission assembly. Thus, these units are subjected to harsher environments than when they are mounted inside the passenger compartment. Accordingly, higher than conventionally required levels of durability become necessary.

In the aforementioned instances, the electronic components could be mounted on a heat-resistant ceramic substrate that is encased in a hermetically sealed casing. However, the adoption of hermetically sealed casings is costly both in terms of components and production and is therefore not a preferable option.

As an inexpensive packaging method, a transfer mold method employing a thermosetting resin, such as an epoxy resin, is generally used for hermetically sealing silicon chips such as LSIs. An example of application of this method is disclosed in JP Patent Publication (Kokai) No. 4-159765 A (1992), where a substrate on which a plurality of electronic components are mounted is integrally molded with an external connection terminal. In the structures disclosed in this publication, no consideration is given to heat-dissipating properties. Structures for improving heat-dissipating properties are disclosed in JP Patent Publication (Kokai) Nos. 7-235633 A (1995), 8-139218 A (1996) and 8-78616 A (1996).

### (Patent Document 1)

JP Patent Publication (Kokai) No. 4-159765 A (1992)

### (Patent Document 2)

JP Patent Publication (Kokai) No. 7-235633 A (1995)

### (Patent Document 3)

JP Patent Publication (Kokai) No. 8-139218 A (1996)

### (Patent Document 4)

JP Patent Publication (Kokai) No. 8-78616 A (1996)

### SUMMARY OF THE INVENTION

The aforementioned inventions relate to relatively small-sized multi-chip modules on which electronic components with small electric capacities are mounted. They are not designed with the kind of durability and heat-dissipating properties in mind that are required when the unit, such as an automobile control unit, involves large currents and includes complicated electrical circuitry and a large wiring circuit board.

Specifically, in the wiring circuit board such as the one for the aforementioned control unit, the components that are mounted generate relatively large amounts of heat. Further, the unit is mounted in a high-temperature environment such as the engine compartment. Therefore, when heat-dissipating properties are considered, a ceramic substrate, which is highly heat-resistant, must be used. However, when a ceramic substrate is entirely sealed with a resin by the transfer mold method, the size of the resulting device becomes significantly larger than the conventional semiconductor, even when the substrate is made up of several layers in order to increase the packaging density.

A typical epoxy resin composition used for the transfer mold method has a coefficient of linear expansion of 8 to 20 ppm/°C, which is larger than the corresponding figure of 5 to 7 ppm/°C for the ceramic substrate. In the conventional structure, peelings can occur at the boundary between the epoxy resin composition and the ceramic substrate, or cracks can be produced in the epoxy resin composition, due to repeated temperature changes. Similar problems of thermal stress are caused in cases where a heat sink is affixed to the wiring circuit board in order to improve the efficiency with which heat is dissipated from the individual electronic components on the substrate. These problems increasingly manifest themselves as the size of the substrate of the unit such as the automobile control unit increases, and as the temperature of the environment in which the unit is mounted increases.

In view of these problems of the prior art, it is the object of the invention to provide a low-cost electronic circuit apparatus and a method of manufacturing the same, in which a balance can be struck among a high packaging density, high heat-dissipating properties and a high reliability even under harsh environments where high heat resistivity and air tightness are required.

In order to achieve the aforementioned objective, the invention provides an electronic circuit apparatus comprising:
at least two wiring circuit boards each of which is mounted with at least two electronic components;
a heat sink on which said wiring circuit boards are fixed, said heat sink having a higher heat conductivity than that of said wiring circuit boards;
an external connection terminal electrically connected to said wiring circuit boards; and
a thermosetting resin composition with which the entire surfaces of said wiring circuit boards, a part of said heat sink and a part of said external connection terminal are integrally molded, wherein:
   said wiring circuit boards on which all of necessary electronic components are mounted in advance are fixed to the top and bottom of said heat sink via an adhesive layer.

The invention further provides a method of manufacturing an electronic circuit apparatus comprising the steps of:
fixing said wiring circuit boards on which said electronic components are mounted to the top and bottom of said heat sink via an adhesive layer.

The invention also provides an electronic circuit apparatus comprising:
a wiring circuit board on which at least two electronic components are mounted;
a heat sink on which said wiring circuit board is mounted, said heat sink having a higher heat conductivity than that of said wiring circuit board;
an external connection terminal electrically connected to said wiring circuit board; and
a thermosetting resin composition with which the entire surface of said wiring circuit board, at least a part of said heat sink and a part of said external connection terminal are integrally molded, wherein:
   a part of a passage for circulating a cooling medium is formed in an external layer of said electronic circuit apparatus simultaneously with the integral molding by the thermosetting resin composition.

In a mounting structure of the invention, the electronic circuit apparatus is mounted on the interior of the transmission assembly of an automobile together by using the aforementioned passage in which the cooling medium can be circulated. By circulating a transmission fluid in this passage, the heat produced in the electronic circuit apparatus can be efficiently dissipated. Alternatively, the electronic circuit apparatus may be mounted in the engine compartment of an automobile, and the engine cooling water may be circulated. Further alternatively, the electronic circuit apparatus may be mounted inside an engine intake pipe, in which the air for engine combustion is circulated.

In another mounting structure of the invention, two or more electronic circuit apparatuses in which the aforementioned cooling passages are formed are stacked on top of each other, and a coolant is circulated in a passage formed between the electronic circuit apparatuses.

### BRIEF DESCRIPTION OF THE DRAWINGS

Fig. 1 is a schematic cross section of the electronic circuit apparatus according to a first embodiment of the invention.
Fig. 2 shows the process of assembling and manufacturing the electronic circuit apparatus according to the first embodiment of the invention.
Fig. 3 shows the mounting layouts of wiring circuit boards mounted on the electronic circuit apparatus of the invention.
Fig. 4 is an exterior view of the electronic circuit apparatus of the invention showing a lead frame and a wiring circuit board, prior to its hermetic molding by a thermosetting resin composition.
Fig. 5 is an exterior view of the electronic circuit apparatus of the invention after its hermetic molding by the thermosetting resin composition and after the formation of an external connection terminal.
Figs. 6 (a) and (b) show processes of assembling and manufacturing the electronic circuit apparatus according to the second embodiment of the invention.
Fig. 7 is a three-dimensional perspective view of the exterior of a finished product of the electronic circuit apparatus according to the second embodiment of the invention.
Fig. 8 shows the process of assembling and manufacturing the electronic circuit apparatus according to a third embodiment of the invention.
Fig. 9 shows the mounting layouts of the wiring circuit boards mounted in the electronic circuit apparatus of the third embodiment.
Fig. 10 is a perspective view of the electronic circuit apparatus according to a fourth embodiment of the invention.
Fig. 11 is a schematic cross section of the electronic circuit apparatus of the fourth embodiment, in an example of the manner in which the electronic circuit apparatus is mounted.
Fig. 12 is a schematic view of a mounting structure in a fifth embodiment of the invention, in which the electronic circuit apparatuses of the fourth embodiment are stacked on top of each other.
Fig. 13 is a schematic view of another mounting structure in the fifth embodiment of the invention, in which the electronic circuit apparatuses of the fourth embodiment are stacked on top of each other.
Fig. 14 is a perspective view of the electronic circuit apparatus according to a sixth embodiment of the invention.
Fig. 15 is a schematic view of the electronic circuit apparatus of the sixth embodiment as it is mounted inside an engine intake pipe.

### DETAILED DESCRIPTION OF THE PREFERRED EMBODIMENTS

Hereafter the embodiments of the invention will be described by referring to the drawings.

### (Embodiment 1)

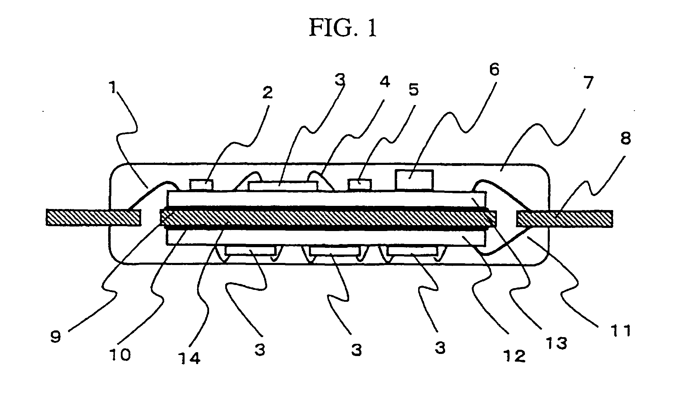

Embodiment 1 will be described by referring to Fig. 1, which shows a cross section of an electronic circuit apparatus according to the invention. Bare silicon chips 3, which include a CPU and an output-stage power IC, are fixed to wiring circuit boards 12 and 13 by soldering or with a conductive paste. Electrodes of the bare silicon chips 3 and the wiring circuit boards 12 and 13 are electrically connected by gold bonding wires 4. Alternatively, a flip-chip connection technology may be used by employing soldering balls, gold bumps, or anisotropic conductive adhesive agent, for example.

Electronic components 2, 5 and 6 are passive components, such as chip resistors and capacitors, and they are mounted on the wiring circuit boards 12 and 13 mainly by soldering. Alternatively, they may be fixed by means of a conductive paste. The wiring circuit boards 12 and 13 used in the invention are not particularly limited and may be those conventionally used in electronic circuit apparatuses. However, from the viewpoints of heat resistivity, heat conductivity and packaging density, it is preferable to use ceramic substrates made of alumina, for example, or glass-ceramics substrates that can be Co-fired. These boards should preferably be constructed as multilayer wiring circuit boards comprising approximately four to eight layers. In order to allow the heat generated in the silicon chips to be swiftly transmitted to a heat sink, a flexible wiring circuit board containing polyimide may be used. The wiring circuit boards 12 and 13 are fixed to a heat sink 14 via adhesive agent 9 and 10 on the upper and lower layers, respectively. The electrical connection between the wiring circuit boards 12 and 13 and an external connection terminal 8 is effected by an aluminum bonding wire 1. While an aluminum wire is preferable for this connection in terms of current density, a gold wire or copper wiring materials, for example may be used. The wiring circuit board 12 at the bottom of Fig. 1 is connected to the external connection terminal 8 via an aluminum bonding wire 11.

The external connection terminal 8 may be made of the same or a different material from that of the heat sink 14. While the external connection terminal 8 may be implemented in any form as long as it can ensure electrical conduction. Preferably, however, the external connection terminal 8 is made of a copper alloy or an iron-nickel alloy that is used in the lead frame in the conventional semiconductor devices. Depending on the method of bonding, a bonding pad of the external connection terminal 8 is nickel- or copper-plated. The areas of the external connection terminal 8 that are not covered by the thermosetting resin 7 should preferably be plated in order to ensure weldability and to protect the surface.

The heat sink 14 used in the invention may be made of any material as long as it has a heat conductivity higher than that of the wiring circuit boards. Metal materials are particularly suitable, as they generally have high heat conductivities. When ceramic substrates are used as the wiring circuit boards 12 and 13, metal composite materials with a low thermal-expansion property may be used in order to ensure good bonding with the wiring circuit boards 12 and 13. Examples of such metal composite materials include a copper-invar-copper three-layer clad material, and a composite material produced by firing copper and copper oxide powders together.

The electronic circuit apparatus of the invention is characterized in that the apparatus is integrally molded with the thermosetting resin composition 7 so that the electric circuitry on the wiring circuit board can be protected from the environment. A high level of reliability can be ensured by this feature when the apparatus is used as an automobile component. The thermosetting resin composition may be any composition that hardens upon application of heat during integral molding. Preferably, an epoxy resin, phenolic resin, or polyimide resin should be used. Further preferably, the composition should contain silica or the like for reducing the coefficient of thermal expansion and improving strength. It is also preferable to add alumina for improved heat conductivity.

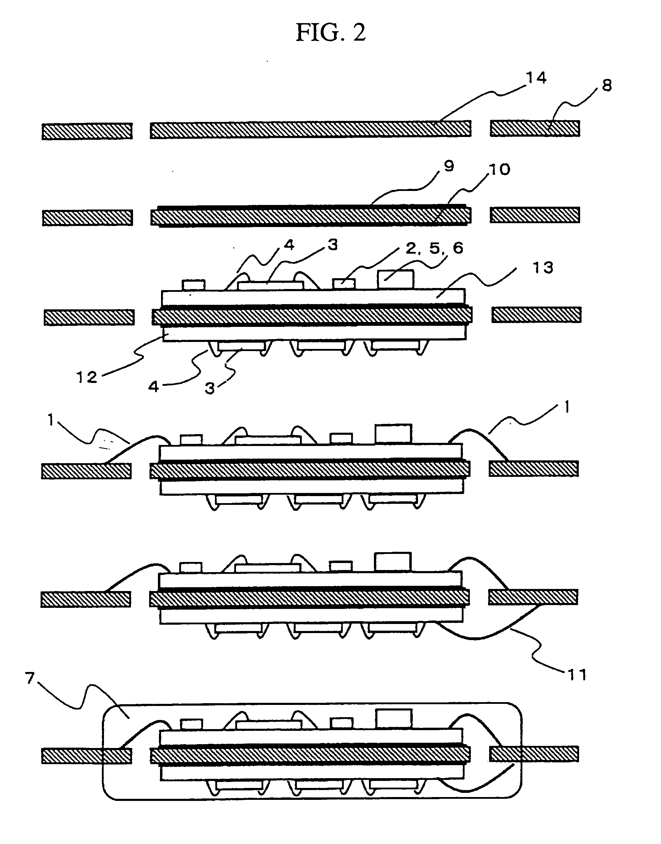

The process of manufacturing the electronic circuit apparatus (Embodiment 1) is described with reference to Fig. 2. First, a substrate comprising the external connection terminal 8 and the heat sink 14 in an integral manner is produced. The inegration process may involve the swaging of two kinds of metal by a press which utilizes the plastic deformation of the metals, or the application of an adhesive agent. Further, the external connection terminal 8 and the heat sink 14 may be made of the same material.

The process of manufacturing the electronic circuit apparatus according to the invention is characterized in that the adhesive agent 9 and 10 is applied to the top and bottom (upper and lower surfaces) of the heat sink 14 for bonding the wiring circuit boards 12 and 13. The method of application may be any conventional one, involving, for example, screen printing, an ink jet process, a dispensing process, a dipping process, electrodeposition, a bar coating process, a curtain coating process, or a combination thereof. A film-like adhesive agent may also be used.

The adhesive agent 9 and 10 used in the invention may be any adhesive agent as long as it is capable of bonding the wiring circuit boards 12 and 13 and the heat sink 14. Preferably, however, a thermosetting resin composition such as an epoxy resin, acrylate resin, methacrylate resin, phenolic resin, polyimide resin, or silicone resin should be used from the viewpoint of workability.

The bare silicon chips are components that generate large amounts of heat on the wiring circuit boards. It is therefore necessary for the portions of the wiring circuit boards and the heat sink immediately below the bare silicon chips to be capable of transmitting heat efficiently. In accordance with the invention, a high heat-conductivity paste is used in this portion in which metal particles or metal oxide particles with high heat conductivity are dispersed in an epoxy resin or an acrylic resin, for example. The metal particles should preferably be made of silver.

Because the wiring circuit boards have some conducting portions that are exposed, if the high heat-conductivity paste of metal particles is electrically conductive, the bonding layer of the invention should preferably be formed of two colors, one an insulating organic paste and the other a high heat-conductivity paste. The process of forming a two-color pattern may involve the aforementioned printing method or dispensing method.

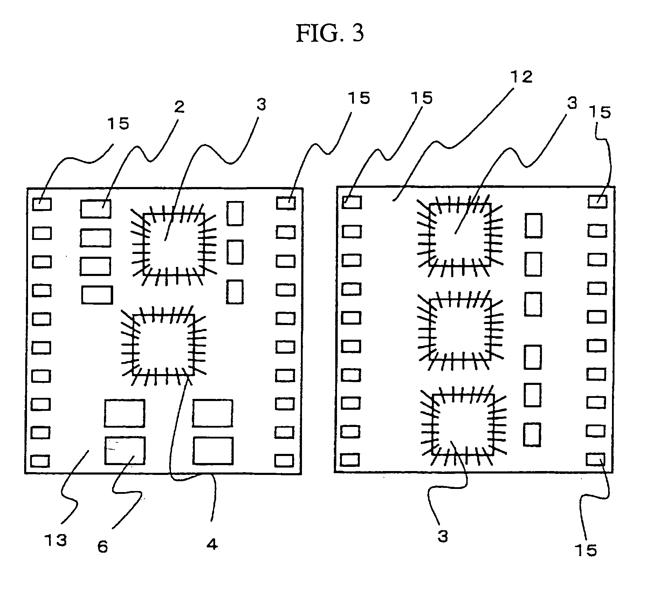

Referring to Fig. 3, the wiring circuit boards 12 and 13 are mounted in advance with the bare silicon chips 3 and electronic components 2, 5 and 6. Thereafter, the external connection terminal 8 is electrically connected to bonding pads 15 on the wiring circuit board 13 by the aluminum bonding wire 1. Further, the external connection terminal 8 is electrically connected to bonding pads 15 on the wiring circuit board 12 by the aluminum bonding wire 11. The wiring circuit boards 12 and 13 are electrically connected as necessary by bonding or other methods. Then, an integral molding of the thermosetting resin composition 7 is performed. For this purpose, the low pressure transfer molding process employed in conventional resin-sealed semiconductor devices may be used. Alternatively, other molding processes for thermosetting resin compositions, such as injection molding, compression molding, printing molding and casting may be used. After the integral molding, a heating process should preferably be conducted in order to ensure the hardening of the thermosetting resin composition. Such a process should be preferably conducted at temperatures not more than 150°C , so as not to alter the properties of the soldering material used for the internal electric connections. After the integral molding, the external connection terminal is mold-plated, for example, thereby completing the electronic circuit apparatus of the invention.

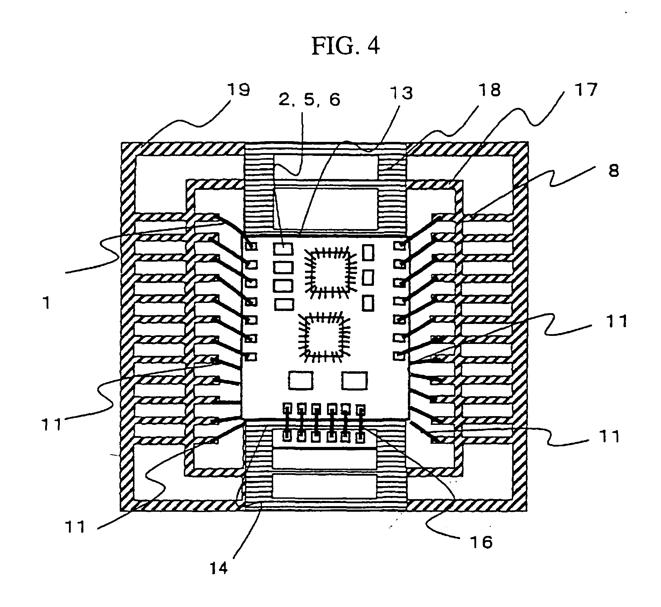

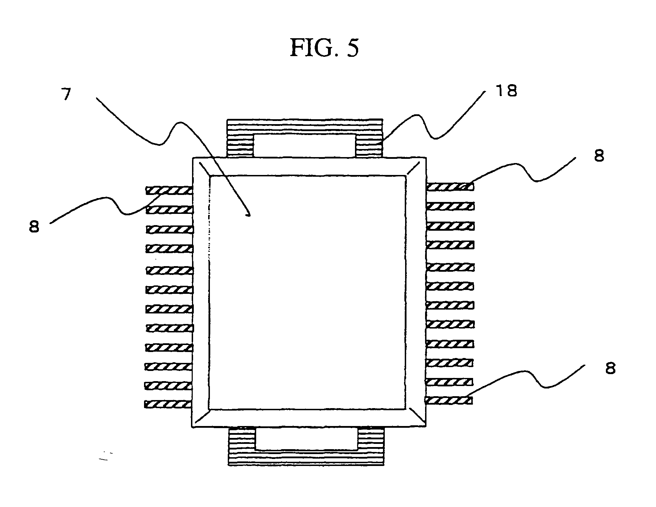

Fig. 4 shows the exterior of the electronic circuit apparatus (Embodiment 1) prior to integral molding. The external connection terminal 8 is fixed to a resin-stopping tie bar 17 and an outer lead frame 19. The outer lead frame 19 and the heat sink 14 are bonded by press molding. The wiring circuit boards 12 and 13, which are fixed to the top and bottom of the heat sink, can be electrically connected by aluminum bonding wires 16. Fig. 5 shows the structure after integral molding in which the resin-stopping tie bar 17 and outer lead frame 19 have been cut off such that the heat sink 14 becomes extended to the outside and in which the heat conducting path also serves as a metal mount 18.

In the electronic circuit apparatus of the invention, a high packaging density and heat-dissipating properties are realized by fixing the wiring circuit boards on the top and bottom of the heat sink. These parts are further integrally molded by a resin, so that a high durability can be obtained.

### (Embodiment 2)

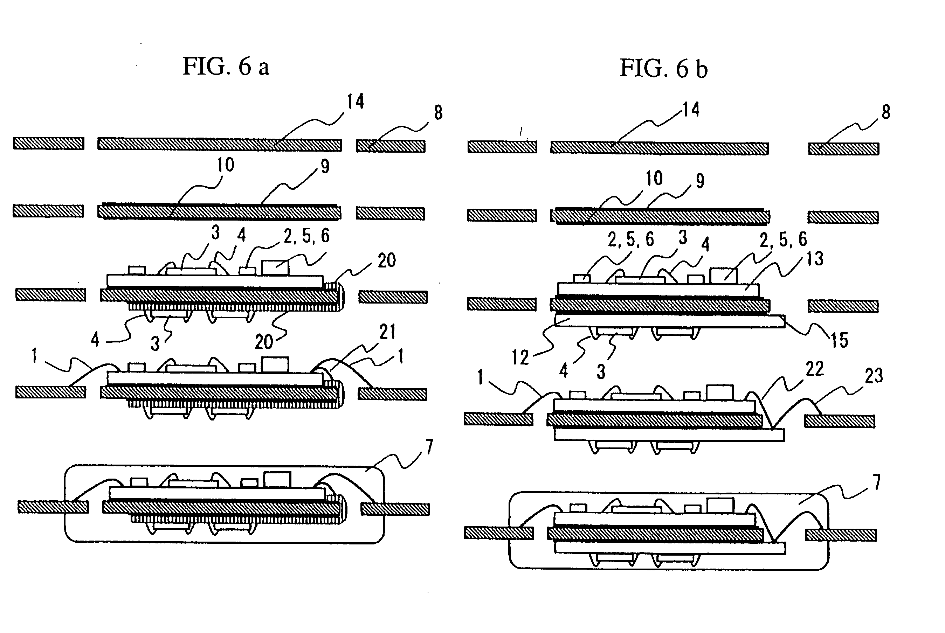

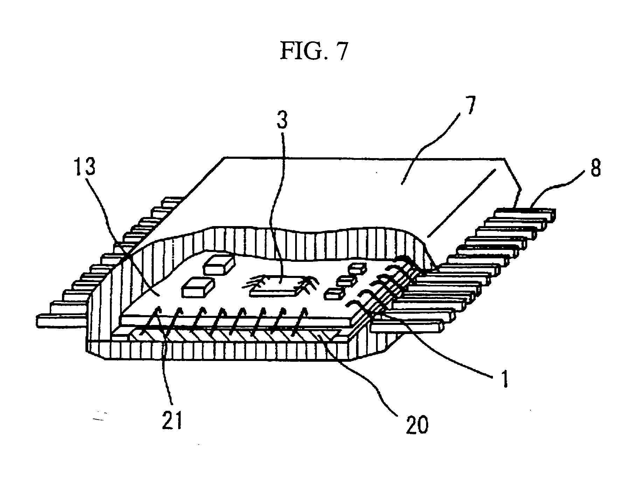

Referring to Figs. 6 and 7, a second embodiment of the invention will be described. The electronic circuit apparatus according to the second embodiment is characterized in that the bonding process for the electrical connections between the external connection terminal and wiring circuit boards and between the wiring circuit boards is conducted on one side of the heat sink.

Fig. 6(a) shows a flexible wiring circuit board 20 fixed to the heat sink 14 by bending such that the upper and lower surfaces of the heat sink 14 are connected. The flexible wiring circuit board 20 is electrically connected to the wiring circuit board 13, which is fixed to the upper surface of the heat sink 14, by an aluminum bonding wire 21. The flexible wiring circuit board 20 may be made of polyimide with copper wiring. A polyimide wiring circuit board is suitable because it is thin and provides good heat conduction between the heat-generating components and the heat sink.

Referring to Fig. 6(b), the wiring circuit board 12 fixed to the lower surface of the heat sink 14 is extended beyond the heat sink 14, and the wiring circuit board 12 is electrically connected to the external connection terminal 8 by an aluminum bonding wire 23. The wiring circuit boards 12 and 13 are connected by an aluminum bonding wire 22. Fig. 7 shows an oblique perspective view of Embodiment 2. The external connection terminal 8 and the wiring circuit board 13 are electrically connected by an aluminum bonding wire 1 at two sides of the wiring circuit board 13. The electrical connection between the wiring circuit board 13 and the flexible wiring circuit board 20 is effected by an aluminum bonding wire 21, so that the bonding pads 15 can be efficiently arranged around the wiring circuit board.

In the electronic circuit apparatus according to Embodiment 2, the wire bonding process can be conducted on one side of the heat sink, so that there is no need to flip the work over or to adjust the position of the bonding tool. Thus, the manufacturing process can be made more efficient, and the electronic circuit apparatus can be obtained at a low cost.

### (Embodiment 3)

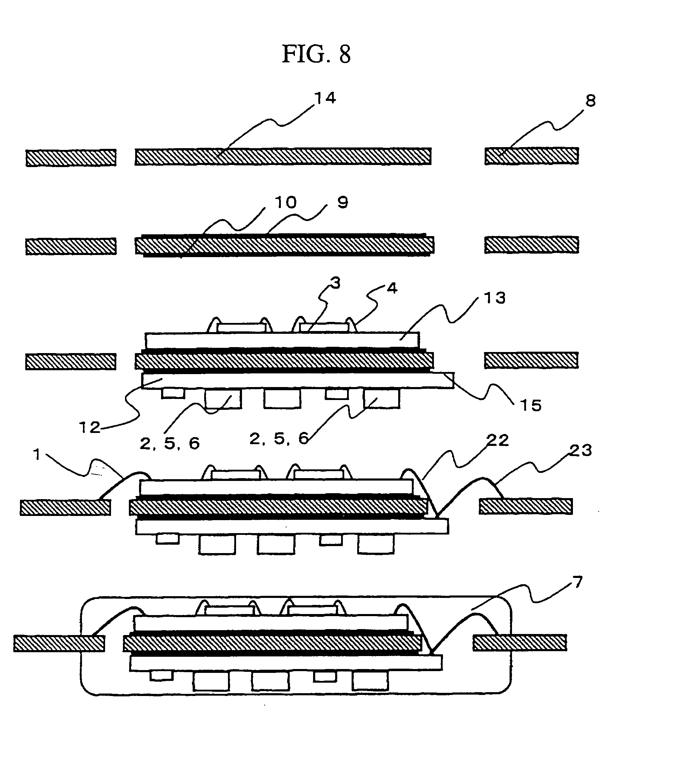

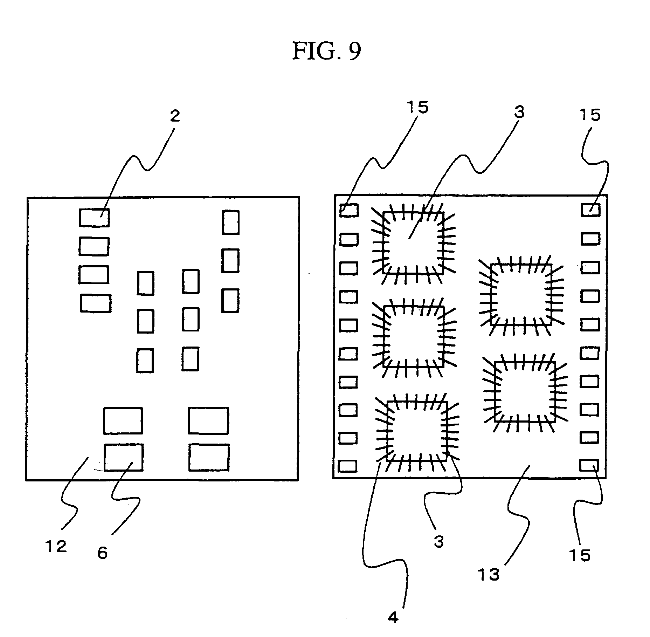

Fig. 8 shows the electronic circuit apparatus according to a third embodiment of the invention. As shown in Fig. 9, only the electronic components 2, 5 and 6 are mounted on the wiring circuit board 12 by reflow soldering or by means of a conductive paste. Bare silicon chips 3 are electrically connected to the wiring circuit board 13 by a gold bonding wire 4. Thus, by separating the reflow soldering packaging on the wiring circuit board 12 and the gold bonding wire 4 on the wiring circuit board 13, it becomes possible to achieve cost reductions in the washing process for each substrate, for example, and therefore reductions in cost can be achieved by process simplification. The possibility of contamination can also be reduced, so that improvements can be achieved in the reliability of connection at the bonding portions and in the adhesion of the boundary between the substrates and the resin. Thus, a highly reliable electronic circuit apparatus can be obtained.

### (Embodiment 4)

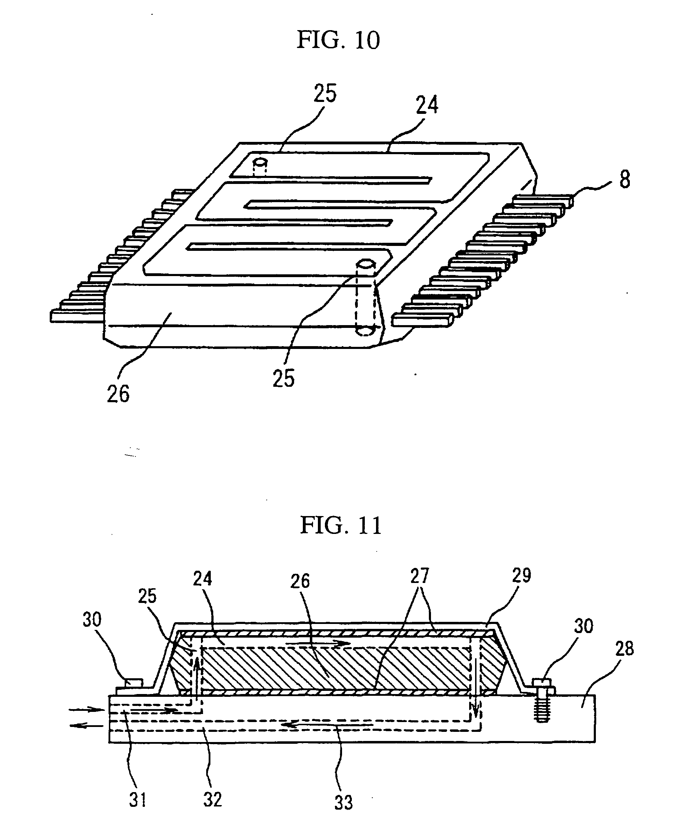

The electronic circuit apparatus according to a fourth embodiment of the invention will be described by referring to Figs. 10 to 13.

In Embodiment 4, a coolant passage 24 and a through passage 25 are formed in the surface of the thermosetting resin composition forming the external layer of the electronic circuit apparatus 26 of the invention. These passages 24 and 25 for a coolant can be formed during the integral molding of the thermosetting resin composition. Fig. 11 shows an example of the packing structure of the electronic circuit apparatus 26. The electronic circuit apparatus 26 provided with the coolant passages is fixed, via a coolant leak-proof packing 27, to a fixing block 28 with a mounting hardware 29 and mounting screws 30. The coolant is introduced via a coolant inlet 31 in the fixing block 28 into the electronic circuit apparatus 26 and is passed through the through passage 25 and coolant passage 24 such that the electronic circuit apparatus 26 is cooled. The coolant then flows in a coolant flow direction 33 and is eventually discharged via a coolant outlet 32.

In the present invention, the coolant may be water-based, oils, air or others. In an example of mounting on an automobile, the electronic circuit apparatus 26 may be mounted inside the transmission assembly, and the transmission oil may be circulated as the coolant. Alternatively, the circulating water in the radiator may be used.

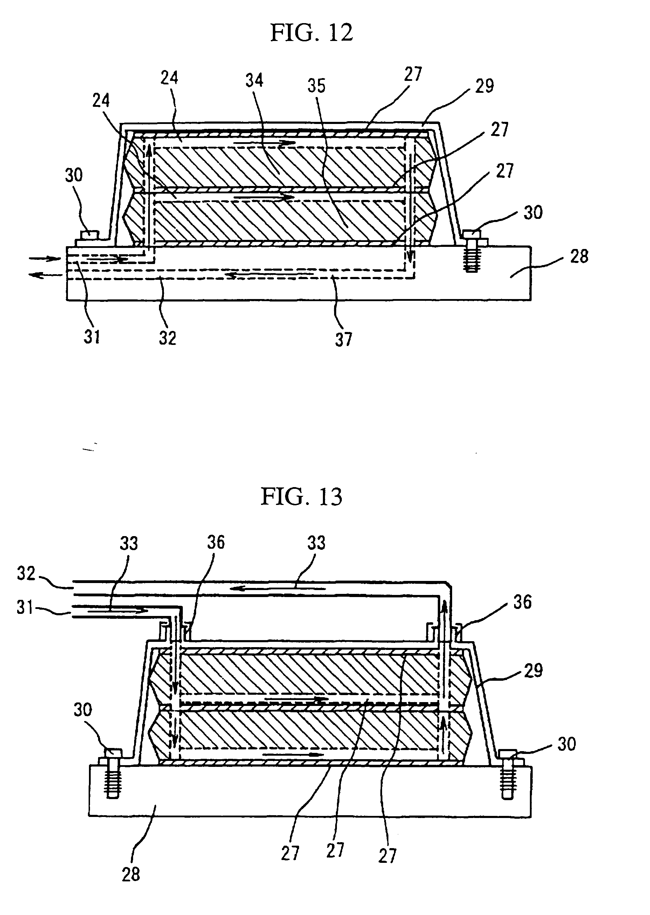

Referring to Figs. 12 and 13, the structure will be described in which the electronic circuit apparatus according to Embodiment 4 is stacked on top of another. Fig. 12 shows two electronic circuit apparatuses 34 and 35 stacked one upon the other which are then secured onto the fixing block 28 by the mounting hardware 29. The coolant is introduced via the inlet 31 and passed through a passage between the electronic circuit apparatuses 34 and 35 and another passage between the stack and the packing 27. After thus cooling the electronic circuit apparatuses 34 and 35, the coolant is discharged via the outlet 32. In the stacked structure, although the packing volume increases, the efficiency with which the heat between the stacked electronic circuit apparatuses 34 and 35 is dissipated can be improved.

In Fig. 13, the coolant passages 32 and 31 are formed as pipes connected to mounting hardware 36, whereby the stacked structure can be cooled more inexpensively and easily.

### (Embodiment 5)

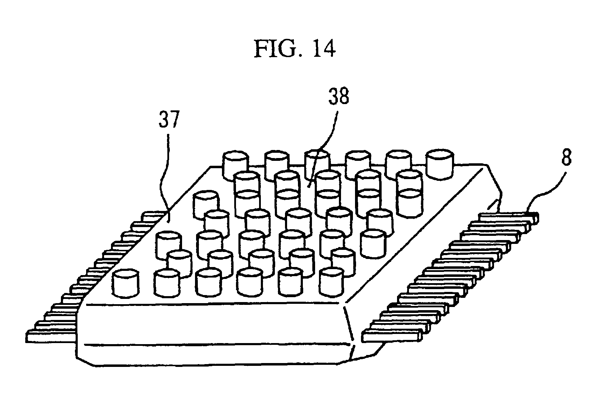

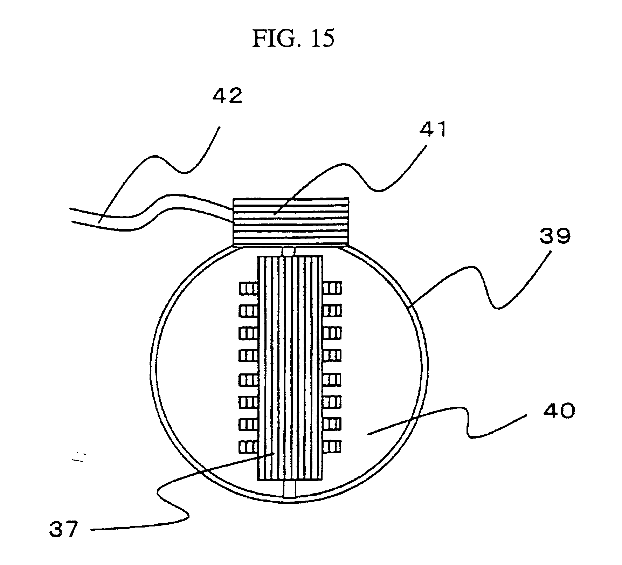

The electronic circuit apparatus according to a fifth embodiment of the invention will be hereafter described by referring to Figs. 14 and 15. Fig. 14 shows projections formed on the surface of the thermosetting resin composition that forms the exterior layer of the electronic circuit apparatus 37, in which air is passed through a passage 38 as the coolant. Fig. 15 shows this electronic circuit apparatus 37 mounted in an air passage 40 inside an intake pipe 39 of the engine of an automobile on which a harness 42 and a connector 41 are mounted. In such an application, the heat can be dissipated from the electronic circuit apparatus of Embodiment 5 very efficiently.

In accordance with the invention, the electronic circuit board is fixed to the upper and lower surfaces of the heat sink, such that the packing process can be simplified, cost can be reduced, and improvements in heat-dissipating property and packaging density can be achieved. Because the entire apparatus is integrally molded with a thermosetting resin composition, the assembly process can be simplified. Even under harsh environments, the electronic circuit apparatus can maintain a high level of hermetic sealing property and remain highly reliable.

## Claims

1. An electronic circuit apparatus comprising:
at least two wiring circuit boards (12, 13) each of which is mounted with at least two electronic components (2, 3, 5, 6);
a heat sink (14) on which said wiring circuit boards (12, 13) are fixed, said heat sink having a higher heat conductivity than that of said wiring circuit boards (12, 13);
an external connection terminal (8) electrically connected to said wiring circuit boards (12, 13); and
a thermosetting resin composition (7) with which the entire surfaces of said wiring circuit boards (12, 13), a part of said heat sink (14) and a part of said external connection terminal (8) are integrally molded, wherein:
said wiring circuit boards (12, 13) on which all necessary electronic components (2, 3, 5, 6) are mounted in advance are fixed to the top and bottom of said heat sink (14) via an adhesive layer.

2. Electronic circuit apparatus according to claim 1, **characterized in that** all of the electronic components mounted on one of said wiring circuit board are mounted by bonding bare chip components (3) with a wire (4), and wherein all of the electronic components (2, 3, 5, 6) mounted on the other wiring circuit board are mounted by soldering.

3. Electronic circuit apparatus according to claim 1 or 2, **characterized in that** a wire bonding between said electronic components and said wiring circuit boards (12, 13), a wire bonding between said wiring circuit boards (12, 13), and a wire bonding between said wiring circuit boards (12, 13) and said external connection terminal are effected only towards one side of said heat sink (14).

4. A method of manufacturing an electronic circuit apparatus comprising the steps of:
fixing at least two wiring circuit boards (12, 13) each of which is mounted with at least two electronic components (2, 3, 5, 6) to a heat sink (14) having a higher heat conductivity than that of said wiring circuit boards (12, 13);
electrically connecting an external connection terminal (8) with said wiring circuit boards (12, 13);
integrally molding the entire surfaces of said wiring circuit boards (12, 13), a part of said heat sink (14) and a part of said external connection terminal (8) with a thermosetting resin composition (7), said method further comprising the step of:
fixing said wiring circuit boards (12, 13) on which said electronic components (2, 3, 5, 6) are mounted to the top and bottom of said heat sink (14) via an adhesive layer (9, 10).

5. Method of manufacturing an electronic circuit apparatus according to claim 4,
**characterized in that** a wire bonding (22) between said wiring circuit boards (12, 13) and a wire bonding (11) between said wiring circuit boards (12, 13) and said external connection terminal (8) are effected only towards one side of said heat sink (14).

6. An electronic circuit apparatus comprising:
a wiring circuit board (12, 13) on which at least two electronic components are mounted;
a heat sink (14) to which said wiring circuit board (12, 13) is fixed, said heat sink (14) having a higher heat conductivity than that of said wiring circuit board (12, 13);
an external connection terminal (8) electrically connected to said wiring circuit board (12, 13); and
a thermosetting resin composition (7) with which the entire surface of said wiring circuit board (12, 13), at least a part of said heat sink (14) and a part of said external connection terminal (8) are integrally molded, wherein:
a part of a passage (24, 25) for circulating a cooling medium is formed in an external layer of said electronic circuit apparatus (26).

7. Electronic circuit apparatus according to any of claims 1 to 3, **characterized in that** a part of a passage (24, 25) for circulating a cooling medium is formed in an external layer of said electronic circuit apparatus (26).

8. A structure for mounting said electronic circuit apparatus according to claim 6 or 7, **characterized in that** said electronic circuit apparatus (26) is fixed on the interior of an automatic transmission assembly of an automobile, and wherein said cooling medium is a transmission fluid.

9. A structure for mounting said electronic circuit apparatus according to claim 6 or 7, **characterized in that** said electronic circuit apparatus (26) is fixed on the interior of an engine compartment of an automobile, and wherein said cooling medium is an engine cooling water.

10. A structure for mounting said electronic circuit apparatus according to claim 6 or 7, **characterized in that** said electronic circuit apparatus (26) is fixed on the interior of an engine intake pipe of an automobile, and wherein said cooling medium is the air that passes in said engine intake pipe.

11. A structure for mounting said electronic circuit apparatus according to claim 6 or 7, **characterized in that** at least two electronic circuit apparatuses (34, 35) are stacked on top of each other, and wherein said cooling medium is circulated in the stacked electronic circuit apparatuses (34, 35).

12. Electronic circuit apparatus according to any of claims 1 to 3, 6 and 7, **characterized in that** said adhesive layer (9, 10) is formed by a two color printing process employing a heat-conducting paste containing a highly heat-conductive metal particle and/or a metal oxide particle, and an insulating organic paste, and wherein said heat-conductive paste is disposed immediately below where a bare silicon chip is mounted on said wiring circuit boards.

13. Electronic circuit apparatus according to any of claims 1 to 3, 6, 7 and 12, **characterized in that** said heat sink (14) is made of a metal compound with electrical conductivity, and wherein said adhesive layer (9, 10) is formed by an insulating organic paste.

14. Electronic circuit apparatus according to claim 13, **characterized in that** said heat sink (14) is made of a clad material containing a copper alloy or copper.

15. Electronic circuit apparatus according to claim 13 or 14, **characterized in that** said adhesive layer is made of a thermosetting resin composition (7) containing an epoxy resin and an inorganic filler.

16. Electronic circuit apparatus according to any of claims 1 to 3, 6, 7 and 12 to 15, **characterized in that** at least one of said wiring circuit boards (12, 13) is a ceramic substrate.

17. Electronic circuit apparatus according to any of claims 1 to 3, 6, 7 and 12 to 16, **characterized in that** at least one of said wiring circuit boards (12, 13) is a flexible polyimide wiring circuit board.
